(19) Europäisches Patentamt
European Patent Office
Office européen des brevets

(11) Veröffentlichungsnummer: **0 007 508**
**B1**

(12) **EUROPÄISCHE PATENTSCHRIFT**

(45) Veröffentlichungstag der Patentschrift: 01.06.83

(21) Anmeldenummer: 79102347.6

(22) Anmeldetag: 09.07.79

(51) Int. Cl.³: C 07 F 9/53, C 07 F 9/32, C 07 F 9/65, C 08 F 2/50, C 08 K 5/53, G 03 C 1/68, G 03 F 1/02

(54) **Acylphosphinoxidverbindungen, ihre Herstellung und ihre Verwendung.**

(30) Priorität: 14.07.78 DE 2830927
14.03.79 DE 2909994
14.03.79 DE 2909992

(43) Veröffentlichungstag der Anmeldung:
06.02.80 Patentblatt 80/3

(45) Bekanntmachung des Hinweises auf die Patenterteilung:
01.06.83 Patentblatt 83/22

(84) Benannte Vertragsstaaten:
BE CH DE FR GB IT NL SE

(56) Entgegenhaltungen:
CH - A - 573 461
DE - A - 125 488
DE - A - 1 518 687
DE - A - 2 556 830
DE - C - 1 010 965
US - A - 3 668 093

(73) Patentinhaber: BASF Aktiengesellschaft
Carl-Bosch-Strasse 38
D-6700 Ludwigshafen (DE)

(72) Erfinder: Lechtken, Peter, Dr. Chem.
Ludwigshafener Strasse 6b
D-6710 Frankenthal (DE)
Erfinder: Buethe, Ingolf, Dr. Chem.
Londoner Ring 15
D-6700 Ludwigshafen-Pfingstweide (DE)
Erfinder: Bronstert, Bernd, Dr. Chem.
Sonnenstrasse 12b
D-6710 Frankenthal (DE)
Erfinder: Hesse, Anton, Dr. Chem.
Peter-Nickel-Strasse 15
D-6946 Luetzelsachsen (DE)
Erfinder: Hoffmann, Gerhard, Dr. Chem.
Pappelstrasse 22
D-6701 Otterstadt (DE)
Erfinder: Jacobi, Manfred, Dr. Chem.
Heidelberger Ring 32b
D-6710 Frankenthal (DE)
Erfinder: Lynch, John, Dr. Chem.
Prager Strasse 33
D-6700 Ludwigshafen (DE)

EP 0 007 508 B1

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

(56) Entgegenhaltungen:
Chemical Abstracts Band 78, Nr. 17, 30. April 1973 Columbus, Ohio, USA
H. KUNZEK et al. "Reaction of acid chlorides with trimethylsilyldiphenylphosphine. II. Preparation and properties of aromatic acid phosphides" Seite 499, Spalte 1, Abstract Nr. 111448 G

Chemical Abstracts Band 69, Nr. 5, 29. Juli 1968 Columbus, Ohio, USA A.
I. RAZUMOV et al. Reactivity of organophosphorus carbonyl-containing compounds. IV. Synthesis properties and structure of acylphosphonates" Seite 1821, Spalte 1, Abstract Nr. 19263 J

Chemical Abstracts Band 72, Nr. 24, 15. Juni 1970 Columbus, Ohio, USA A.
N. PUDOVIK "Reactions of dibutyl- and diphenylphosphinous acids with saturated and unsaturated carboxylic acid chlorides" Seite 382, Spalte 2, Abstract Nr. 132877 N

Erfinder: Trimborn, Werner, Dr. Chem.
Hardenburgstrasse 22
D-6703 Limburgerhof (DE)
Erfinder: Vyvial, Rudolf, Dipl.-Ing.
Alwin-Mittasch-Platz 11
D-6700 Ludwigshafen (DE)

Acylphosphinoxidverbindungen, ihre Herstellung und ihre Verwendung

Die vorliegende Erfindung betrifft neue Acylphosphinoxid verbindungen sowie ihre Herstellung und Verwendung als Photoinitiatoren in photopolymerisierbaren Massen, wie Überzugsmitteln, Lacken und Druckfarben.

Es sind bereits eine Reihe von Photoinitiatoren verschiedenster Strukturen bekannt, z.B. aromatische Ketone wie Acetophenon- und Benzophenonderivate und Benzilketale, z.B. Benzildimethylketal (DE—OS 22 61 383), Benzoinäther (DE—OS 16 94 149), Thioxanthone (DE—OS 20 03 132) u.a.m. Photopolymerisierbare Massen, die mit derartigen Initiatorsystemen gehärtet werden, zeigen jedoch eine unerwünschte Vergilbung, die eine Verwendung dieser Systeme auf hellen (bzw. weißen) Flächen oder als Überzug für farbtreue Abbildungen unbrauchbar macht. Dies gilt auch für die in der US—A—3668093 beschriebenen Acylphosphinverbindungen, die überdies in ihrer Aktivität schlechter sind als die oben bezeichneten Photoinitiatoren, die den Stand der Technik repräsentieren.

Gegenstand der vorliegenden Erfindung sind Acylphosphinoxidverbindungen der allgemeinen Formel (I)

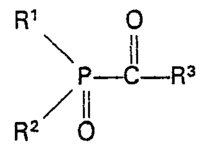

(I)

wobei

$R^1$ für einen geradkettigen oder verzweigten Alkylrest mit 1 bis 6 Kohlenstoffatomen, den Cyclohexyl-, den Cyclopentyl-, einen Aryl-, halogen-, alkyl- oder alkoxyl-substituierten Aryl-, einen S- oder N-haltigen fünf- oder sechsgliedrigen heterocyclischen Rest steht;

$R^2$ die Bedeutung von $R^1$ hat, wobei $R^1$ und $R^2$ untereinander gleich oder verschieden sein können, oder für einen Alkoxyrest mit 1 bis 6 Kohlenstoffatomen, für einen Aryloxy- oder einen Arylalkoxyrest steht, oder $R^1$ und $R^2$ zusammen mit dem P-Atom einen Benzo-1,3,2-dioxaphospholanring bilden;

$R^3$ für einen geradkettigen oder verzweigten Alkylrest mit 2 bis 18 Kohlenstoffatomen, einen 3 bis 12 Kohlenstoffatome enthaltenden cycloaliphatischen Rest, einen alkyl-, alkoxy-, alkylthiosubstituierten Phenyl- oder Naphthylrest, den Thienyl- oder Pyridylrest, einen $\beta$-Acetoxyäthyl- oder $\beta$-Carboxyäthylrest oder für die Gruppierung

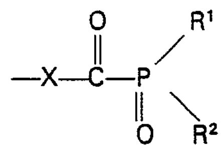

steht, worin $R^1$ und $R^2$ die oben angegebene Bedeutung haben und X für einen Phenylenrest oder einen 2 bis 6 Kohlenstoffatome enthaltenden aliphatischen oder 3 bis 6 Kohlenstoffatome enthaltenden cycloaliphatischen zweiwertigen Rest steht;
und wobei gegebenenfalls mindestens einer der Reste $R^1$ bis $R^3$ olefinisch ungesättigt ist, mit der Maßgabe, daß Verbindungen der Formeln

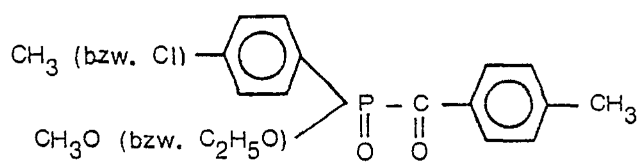

und

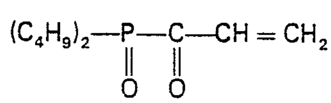

ausgenommen werden.

Gegenstand der vorliegenden Erfindung ist außerdem ein Verfahren zur Herstellung der erfindungsgemäßen Acylphosphinoxidverbindungen.

Gegenstand der vorliegenden Erfindung ist auch die Verwendung der Acylphosphinoxidverbindungen nach Formel (II), wobei

$R^{3\prime}$ zusätzlich zu $R^3$ einen Methyl- oder Phenylrest bedeuten kann, sowie der Acylphosphinoxidverbindungen der Formeln

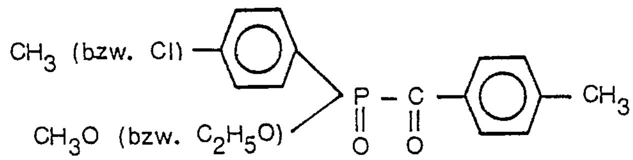

und

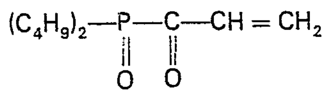

als Photoinitiatoren in photopolymerisierbaren Massen, insbesondere Überzugsmitteln, Lacken und Druckfarben.

Bezüglich der allgemeinen Formel (I) der erfindungsgemäßen Acylphosphinoxidverbindungen ist im einzelnen folgendes auszuführen:

$R^1$ kann sein ein geradkettiger oder verzweigter Alkylrest mit 1 bis 6 C-Atomen, wie Methyl-, Äthyl-, i-Propyl-, n-Propyl-, n-Butyl-, Amyl-, n-Hexyl-, Cyclopentyl-, Cyclohexyl-, Aryl-, wie Phenyl-, Naphthyl-, halogensubstituiertes Aryl, wie Mono- oder Dichlorophenyl-, alkylsubstituiertes Phenyl- wie Methylphenyl-, Äthylphenyl-, Isopropylphenyl-, tert.-Butylphenyl-, Dimethylphenyl-, alkoxysubstituiertes Aryl-, wie Methoxyphenyl-, Äthoxyphenyl-, Dimethoxyphenyl-, S- oder N-haltige fünf- oder sechsgliedrige Ringe, wie Thienyl-, Pyridyl-.

Außer der Bedeutung von $R^1$ kann $R^2$ sein ein Alkoxyrest mit 1 bis 6 C-Atomen, wie Methoxy-, Äthoxy-, i-Propoxy-, Butoxy-, Äthyloxyäthoxy-, ein Aryloxyrest, wie Phenoxy-, Methylphenoxy-, ein arylsubstituierter Alkoxylrest, wie Benzyloxy-;

$R^1$ kann mit $R^2$ zu einem Benzo- 1,3,2-dioxaphospholanring verbunden sein.

$R^3$ kann sein ein Äthyl-, i-Propyl-, n-Propyl-, n-Butyl-, i-Butyl-, tert.-Butyl-, i-Amyl-, n-Hexyl-, Heptyl-, n-Octyl-, 2-Äthylhexyl-, i-Nonyl-, Dimethylheptyl-, Lauryl-, Stearyl-, Cyclopropyl-, Cyclobutyl-, Cyclopentyl-, i-Methylcyclopentyl-, Cyclohexyl-, l-Methylcyclohexyl-, Norbornadienyl-, Adamantyl-, Dimethyloctyl-, Dimethylnonyl-, Dimethyldecyl-, Methylphenyl-, Dimethylphenyl-, Trimethylphenyl-, tert.-Butylphenyl-, Isopropylphenyl-, Methoxyphenyl-, Dimethoxyphenyl-, i-Propoxyphenyl-, Methylthiophenyl-, $\alpha$- und $\beta$-Naphthyl-, Thienyl-, Pyridyl-, $\beta$-Acetoxyäthyl- oder $\beta$-Carboxyäthylrest.

$R^1$ und $R^2$ können außerdem C—C-Doppelbindungen enthalten, die es erlauben, den Photoinitiator in das Bindemittel einzupolymerisieren.

Als Beispiele für die erfindungsgemäßen Acylphosphinoxidverbindungen seien genannt:

Isobutyroyl-methylphosphinsäuremethylester
Isobutyroyl-phenylphosphinsäuremethylester
Pivaloyl-phenylphosphinsäuremethylester
2-Äthylhexanoyl-phenylphosphinsäuremethylester
Pivaloyl-phenylphosphinsäureisopropylester
p-Toluyl-phenylphosphinsäuremethylester
o-Toluyl-phenylphosphinsäuremethylester
2,4-Dimethylbenzoyl-phenylphosphinsäuremethylester
p-tert.-Butyl-benzoylphenylphosphinsäureisopropylester
Pivaloyl-(4-methylphenyl)-phosphinsäuremethylester
Pivaloyl-phenylphosphinsäurevinylester
Acryloyl-phenylphosphinsäuremethylester
Isobutyroyl-diphenylphosphinoxid
Pivaloyl-diphenylphosphinoxid
1-Methyl-1-cyclohexanoyl-diphenylphosphinoxid
2-Athylhexanoyl-diphenylphosphinoxid
p-Toluyl-diphenylphosphinoxid
o-Toluyl-diphenylphosphinoxid
p-tert.-Butylbenzoyldiphenylphosphinoxid
3-Pyridylcarbonoyl-diphenylphosphinoxid
Acryloyldiphenylphosphinoxid
Benzoyl-diphenylphosphinoxid
2,2-Dimethyl-heptanoyl-diphenylphosphinoxid

Terephthaloyl-bis-diphenylphosphinoxid
Adipoyl-bis-diphenylphosphinoxid.

Die Herstellung derartiger Verbindungen gelingt durch Umsetzung von Säurehalogeniden der Formel

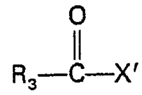

X′ = Cl, Br, mit Phosphinen der Formel

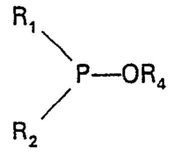

$R_4$ = geradkettiger oder verzweigter $C_1$- bis $C_6$-Alkyl-, oder Cycloalkylrest mit 5 oder 6 C-Atomen.

Die Umsetzung kann in einem Lösungsmittel wie einem Kohlenwasserstoff oder Kohlenwasserstoffgemisch wie Petroläther, Toluol, Cyclohexan, einem Äther, anderen üblichen inerten organischen Lösungsmitteln, oder auch ohne Lösungsmittel bei Temperaturen zwischen −30°C und +130°C, bevorzugt bei 10 bis 100°C, ausgeführt werden. Das Produkt kann aus dem Lösungsmittel direkt auskristallisiert werden, hinterbleibt nach dem Abdampfen oder wird im Vakuum destilliert.

Die Herstellung der Säurehalogenide

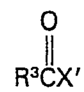

und des substituierten Phosphins $R^1R^2POR^4$ erfolgt nach Verfahren, die dem Fachmann aus der Literatur bekannt sind (z.B. Weygand-Hilgetag, Organisch-Chemische Experimentierkunst, 4. Auflage, S. 246—256, J. A. Barth-Verlag, Leipzig 1970 sowie K. Sasse in Houben-Weyl, Band 12/1, S. 208—209, G. Thieme-Verlag, Stuttgart).

Das Verfahren zur Herstellung der erfindungsgemäßen Verbindungen läßt sich folgendermaßen beispielhaft beschrieben:

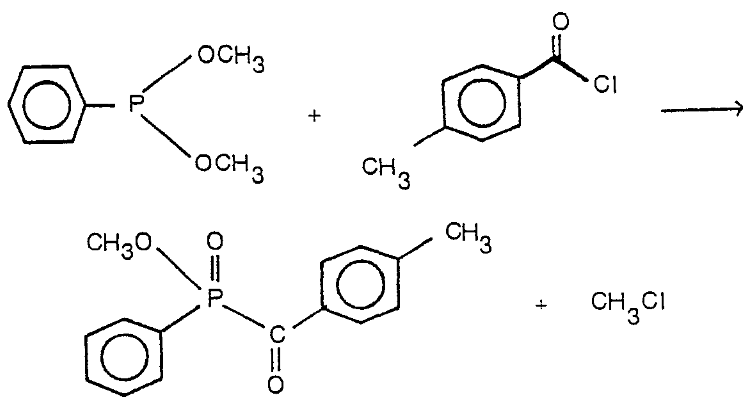

bzw.

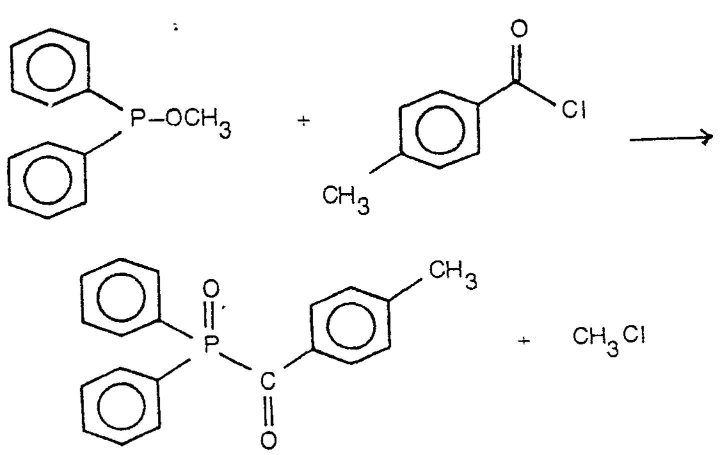

Geeignete Phosphine sind zum Beispiel Methyldimethoxyphosphin, Butyldimethoxyphosphin, Phenyldimethoxyphosphin, Tolyldimethoxyphosphin, Phenyldiäthoxyphosphin, Tolyldiäthoxyphosphin, Phenyldiisopropoxyphosphin, Tolyldiisopropoxyphosphin, Phenyldibutoxyphosphin, Toluyldibutoxyphosphin bzw. Dimethylmethoxyphosphin, Dibutylmethoxyphosphin, Dimethylbutoxyphosphin, Diphenylmethoxyphosphin, Diphenyläthoxyphosphin, Diphenylpropoxyphosphin, Diphenylisopropoxyphosphin, Diphenylbutoxyphosphin die zu den erfindungsgemäßen Verbindungen führen.

Als Säurehalogenide eignen sich Chloride und Bromide, besonders bevorzugt sind jedoch Säurechloride.

Beispiele für die erfindungsgemäßen Verbindungen sind insbesondere folgende:

TABELLE 1

Beispiele der erfindungsgemäßen Verbindungen (Ph = Phenyl)

| Verbindung | Schmp. (°C) | Sdp. (°C) | Ausbeute | | Analyse C | Analyse N | Analyse P |
|---|---|---|---|---|---|---|---|
| 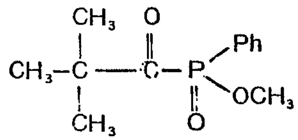 | – | 104/40 Pa | 65% | ber. | 60,0 | 7,08 | 12,9 |
| | | | | gef. | 59,8 | 6,9 | 12,4 |
| 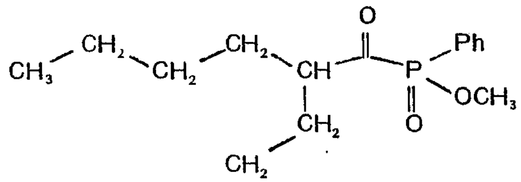 | – | 164/160 Pa | 65% | ber. | 64,06 | 7,83 | 11,03 |
| | | | | gef. | 63,8 | 8,1 | 11,0 |
| 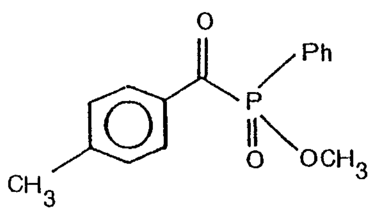 | 101 | – | 70% | ber. | 65,69 | 5,47 | 11,31 |
| | | | | gef. | 65,7 | 5,6 | 11,0 |
| 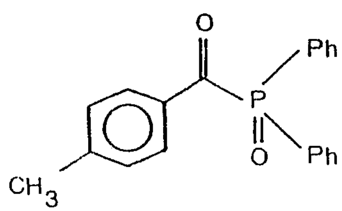 | 105 | – | 73% | ber. | 75,00 | 5,31 | 9,69 |
| | | | | gef. | 75,3 | 5,8 | 9,3 |
| 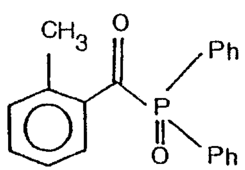 | 107 | – | 84% | ber. | 75,00 | 5,31 | 9,69 |
| | | | | gef. | 74,7 | 5,4 | 9,5 |

| Verbindung | Schmp. (°C) | Sdp. (°C) | Ausbeute | | Analyse C | N | P |
|---|---|---|---|---|---|---|---|
| 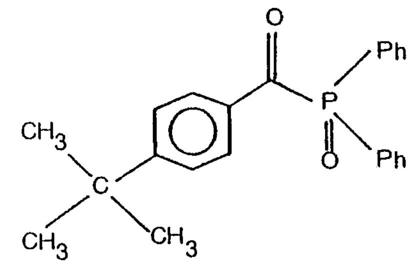 | 136 | – | 83% | ber. | 76,24 | 6,35 | 8,56 |
| | | | | gef. | 76,0 | 6,5 | 8,7 |
| 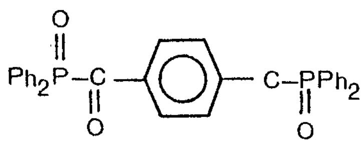 | 205 | – | 35% | ber. | 71,91 | 4,49 | 11,61 |
| | | | | gef. | 71,8 | 4,8 | 11,0 |
| 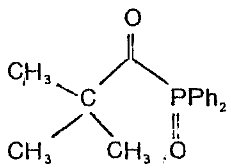 | 114 | – | 81% | ber. | 71,33 | 6,64 | 10,84 |
| | | | | gef. | 71,0 | 6,5 | 11,0 |
| 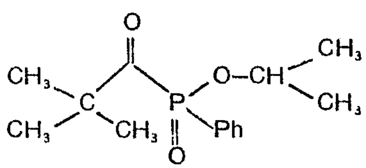 | – | 120/67 Pa | 60% | ber. | 62,68 | 7,84 | 11,57 |
| | | | | gef. | 63,0 | 8,0 | 11,4 |
| 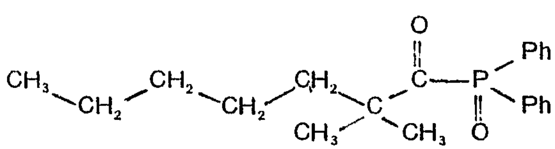 | – | – | 90% | ber. | 73,68 | 7,89 | 9,06 |
| | | | | gef. | 73,6 | 8,1 | 8,6 |

| Verbindung | Schmp. (°C) | Sdp. (°C) | Ausbeute | | Analyse C | N | P |
|---|---|---|---|---|---|---|---|
| 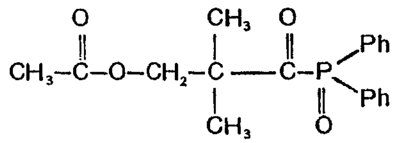 | – | – | 90% | ber. | 66,28 | 6,11 | 9,01 |
| | | | | gef. | 65,9 | 6,1 | 8,6 |
| 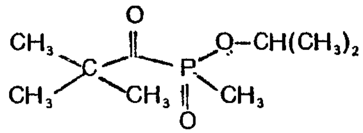 | – | 51°/40 Pa | 80% | ber. | 52,43 | 9,22 | 15,05 |
| | | | | gef. | 52,1 | 9,1 | 14,9 |
| 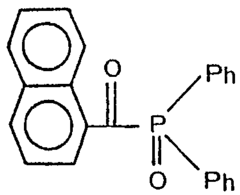 | 166 | – | 65% | ber. | 77,52 | 4,79 | 8,71 |
| | | | | gef. | 77,7 | 4,8 | 8,4 |
| 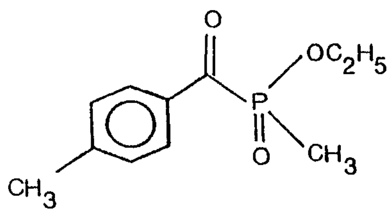 | – | 102°/7 Pa | 60% | ber. | 58,41 | 6,64 | 13,71 |
| | | | | gef. | 58,9 | 6,7 | 13,5 |
| 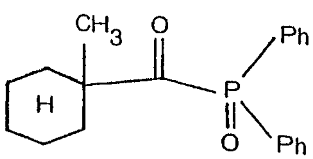 | 80 | – | 26% | ber. | 73,62 | 7,06 | 9,51 |
| | | | | gef. | 73,3 | 7,1 | 9,6 |
| 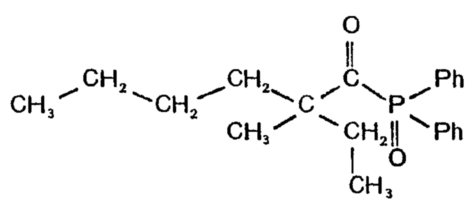 | – | – | 90% | ber. | 73,68 | 7,89 | 9,06 |
| | | | | gef. | 73,9 | 8,1 | 9,4 |

Die Verbindungen der erfindungsgemäßen Struktur zeigen eine sehr gute Reaktivität als Photoinitiatoren für photopolymerisierbare Monomere mit mindestens einer C—C-Mehrfachbindung und Mischungen derselben miteinander und mit bekannten Zusatzstoffen. Die erfindungsgemäßen Acylphosphinoxidverbindungen eignen sich besonders gut als Photoinitiatoren in photopolymerisierbaren Massen für Überzüge und Lacke. Sie sind hinsichtlich der Vergilbung der so erhaltenen Lacke bzw. Überzüge bekannten Photoinitiatoren (z.B. Benzildimethylketal) weit überlegen.

Bevorzugt sind dabei Acyl-phenyl-phosphinsäureester bzw. Acyldiphenylphosphinoxide, deren Acylrest sich von einer sekundär- oder tertiär-substituierten aliphatischen Carbonsäure wie Pivalinsäure, 1-Methylcyclohexancarbonsäure, Norbornencarbonsäure, $\alpha,\alpha$-Dimethylalkancarbonsäuren (Versatic®-Säure mit 9 bis 13 Kohlenstoffatomen), 2-Äthylhexancarbonsäure, oder von einer substituierten aromatischen Carbonsäure wie p-Methylbenzoesäure, o-Methylbenzoesäure, 2,4-Dimethylbenzoesäure, p-tert.-butylbenzoesäure, 2,4,5-Trimethylbenzoesäure, p-Methoxybenzoesäure oder p-Methylthiobenzoesäure ableiten.

Als photopolymerisierbare Monomere eignen sich die üblichen Verbindungen und Stoffe mit polymerisierbaren C—C-Doppelbindungen, die durch z.B. Aryl-, Carbonyl, Amino-, Amid-, Amido-, Ester-, Carboxy- oder Cyanid-Gruppen, Halogenatome oder C—C-Doppel- oder C—C-Dreifachbindungen aktiviert sind. Genannt seien beispielsweise Vinyläther und Vinylester, Styrol, Vinyltoluol, Acrylsäure und Methacrylsäure sowie deren Ester mit ein- und mehrewertigen Alkoholen, deren Nitrile oder Amide, Malein- und Fumarester sowie N-Vinylpyrrolidon, N-Vinylcaprolactam, N-Vinylcarbazol und Allylester wie Diallylphthalat.

Als polymerisierbare höhermolekulare Verbindungen sind beispielsweise geeignet: ungesättigte Polyester, hergestellt aus $\alpha,\beta$-ungesättigten Dicarbonsäuren wie Maleinsäure, Fumarsäure oder Itaconsäure, gegebenenfalls im Gemisch mit gesättigten bzw. aromatischen Dicarbonsäuren, wie Adipinsäure, Phthalsäure, Tetrahydrophthalsäure oder Terephthalsäure, durch Umsetzung mit Alkandiolen wie Äthylenglykol, Propylenglykol, Butandiol, Neopentylglykol oder oxalkyliertem Bisphenol A; Epoxidacrylate, hergestellt aus Acryl- oder Methacrylsäure und aromatischen oder aliphatischen Diglycidyläthern und Urethanacrylate (z.B. hergestellt aus Hydroxyalkylacrylaten und Polyisocyanaten), sowie Polyesteracrylate (z.B. hergestellt aus hydroxylgruppenhaltigen gesättigten Polyestern und Acryl- oder Methacrylsäure).

Gegebenenfalls können die photopolymerisierbaren Überzugsmittel, Lacke und Druckfarben auch als wäßrige Dispersionen vorliegen oder zur Anwendung gebracht werden.

Den photopolymerisierbaren Verbindungen, deren Zusammensetzung für den jeweiligen Verwendungszweck dem Fachmann geläufig ist, können in an sich bekannter Weise gesättigte und/oder ungesättigte Polymere sowie weitere Zusatzstoffe wie Inhibitoren gegen die thermische Polymerisation, Paraffin, Pigmente, Farbstoffe, Peroxide, Verlaufshilfsmittel, Füllstoffe, Mattierungsmittel und Glasfasern sowie Stabilisatoren gegen thermischen oder photochemischen Abbau zugesetzt sein.

Solche Gemische sind dem Fachmann bekannt und Art und Menge der Zusätze hängen vom jeweiligen Verwendungszweck ab.

Die erfindungsgemäßen Verbindungen werden dabei im allgemeinen in einer Konzentration von 0,001 bis 20%, insbesondere von 0,01 bis 15%, vorzugsweise von 0,1 bis 5%, bezogen auf die photopolymerisierbare Masse, eingesetzt. Sie können gegebenenfalls mit Beschleunigern kombiniert werden, die den hemmenden Einfluß des Luftsauerstoffs auf die Photopolymerisation beseitigen.

Solche Beschleuniger bzw. Synergisten sind beispielsweise sekundäre und/oder tert. Amine wie Methyldiäthanolamin, Dimethyläthanolamin, Triäthylamin, Triäthanolamin, p-Dimethylaminobenzoesäureäthylester, Benzyl-dimethylamin, Dimethylaminoäthylacrylat, N-Phenylglycin, N-Methyl-N-Phenylglycin und analoge, dem Fachmann bekannte Verbindungen. Zur Beschleunigung der Aushärtung können weiterhin aliphatische und aromatische Halogenide dienen wie 2-Chloromethylnaphthalin, 1-Chlor-2-chlormethy-naphthalin, sowie Radikalbildner wie Peroxide und Azo-Verbindungen.

Als Strahlungsquellen für das die Polymerisation solcher Mischungen auslösende Licht verwendet man solche, die Licht vorzugsweise im Absorptionsbereich der erfindungsgemäßen Verbindungen aussenden, d.h. zwischen 230 und 450 nm. Besonders geeignet sind Quecksilber-Niederdruckstrahler, -Mitteldruck- und Hochdruckstrahler, sowie (superaktinische) Leuchtstoffröhren oder Impulsstrahler. Die genannten Lampen können gegebenenfalls dotiert sein.

Die in den nachstehenden Beispielen genannten Teile und Prozente beziehen sich, soweit nicht anders angegeben, auf das Gewicht. Volumenteile verhalten sich zu Teilen wie Liter zu Kilogramm.

Beispiel 1

Zu einer Mischung aus 1350 Volumenteilen Petroläther (Siedebereich 40—70°C), 180 Volumenteilen N,N-Diäthylanilin und 67 Volumenteilen Methanol werden unter Rühren bei 0°C 225 Teile Diphenylchlorphosphin, gelöst in 220 Volumenteilen Petroläther, zugegeben. Danach rührt man die Mischung noch 2 Stunden bei Raumtemperatur. Nach Abkühlung auf ca. +5°C saugt das ausgeschiedene Aminhydrochlorid ab und destilliert das Filtrat zunächst bei 1300—2500 Pa, um alles Leichtsiedende zu entfernen. Sodann wird das Diphenylmethoxyphosphin bei 13 bis 130 Pa fraktioniert destilliert. Sdp. $_{67\ Pa}$ 120—124°C. Ausbeute: 175 Teile (80% bezogen auf Diphenylchlorphosphin).

Zu 36,2 Teilen Pivaloylchlorid tropft man unter Rühren bei 30—60°C 64,8 Teile Diphenylmethoxyphosphin zu. Nach vollendeter Zugabe läßt man noch 30 min nachreagieren, kühlt auf 0—10°C ab und kristallisiert das ausgefallene Produkt aus Cyclohexan um.

Ausbeute: 69,5 Teile Pivaloyldiphenylphosphinoxid (81% der Theorie).
Schmp. 110—112°C, NMR ($CDCl_3$, $\delta$), 1,33 (S), 7,4—8,0 (m)

| | | | |
|---|---|---|---|
| Analyse $C_{17}H_{19}O_3P$ (286): | C 71,33 | H 6,64 | P 10,84 |
| gef.: | C 71,0 | H 6,5 | P 11,0 |

Beispiel 2

Zu 77 Teilen Toluylsäurechlorid werden 108 Teile Methoxydiphenylphosphin (nach Beispiel 1 hergestellt), gelöst in 200 Volumenteilen Toluol, zugegeben. Danach wird 60 min auf 50°C erwärmt, dann abgekühlt, der Niederschlag von Toluyldiphenylphosphinoxid abgesaugt und aus Cyclohexan umkristallisiert. Ausbeute 117 Teile (73% d. Th.), Schmp. 105°C

NMR ($CDCl_3$, $\delta$): 2,35 (S); 7,2—8 (m)

| | | | |
|---|---|---|---|
| Analyse $C_{20}H_{17}O_2P$ (320) ber.: | C 75,00 | H 5,31 | P 9,69 |
| gef.: | C 75,3 | H 5,8 | P 9,3 |

Beispiel 3

In Analogie zu Beispiel 2 werden aus 77 Teilen 2-Methylbenzoesäurechlorid und 108 Teilen Methoxydiphenylphosphin 134 Teile 2-Methylbenzoyl-diphenylphosphinoxid hergestellt. Ausbeute 84% d.Th., Schmp. 107°C

NMR ($CDCl_3$, $\delta$): 2.5 (S); 7.2—8 (m); 8.8 (m)

| | | | |
|---|---|---|---|
| Analyse $C_{20}H_{17}O_2P$ (320) ber.: | C 75,0 | H 5,31 | P 9,69 |
| gef.: | C 74,7 | H 5,4 | P 9,5 |

Beispiel 4

In Analogie zu Beispiel 1 werden 41,3 Teile p-tert.-Butylbenzoesäurechlorid mit 45,4 Teilen Methoxydiphenylphosphin, gelöst in 20 Teilen Toluol, bei 50°C in 90 min umgesetzt. Nach dem Abdampfen des Lösungsmittels am Rotations-Verdampfer wird aus Cyclohexan umkristallisiert.

Ausbeute: 63 Teile (83% d. Th.) Schmp. 136°C
NMR ($CDCl_3$, $\delta$): 1.3 (S); 7.3—8.1 (m); 8.5 (d)

| | | | |
|---|---|---|---|
| Analyse $C_{23}H_{23}O_2P$ (362) ber.: | C 76,24 | H 6,35 | P 8,56 |
| gef.: | C 76,0 | H 6,5 | P 8,7 |

Beispiel 5

In Analogie zu Beispiel 2 werden aus 52 Teilen Terephthalsäuredichlorid, gelöst in 200 Teilen Toluol, und 108 Teilen Methoxydiphenylphosphin 46 Teile Terephthaloyl-bis-diphenylphosphinoxid hergestellt (Ausbeute 35% d.Th.) Schmp. 205°C.

NMR ($CDCl_3$, $\delta$): 6.8—8.2 (m)

| | | | |
|---|---|---|---|
| Analyse $C_{32}H_{24}O_4P_2$ (534) ber.: | C 71,91 | H 4,49 | P 11,61 |
| gef.: | C 71,8 | H 4,8 | P 11,0 |

Beispiel 6

In der Arbeitsweise wie nach Beispiel 2 werden aus 80 Teilen 1-Methyl-1-cyclohexancarbonsäurechlorid und 108 Teilen Methoxydiphenylphosphin ohne Lösungsmittel 100 Teile 1-Methylcyclohexylcarbonyldiphenylphosphinoxid als öliges Rohprodukt erhalten, das durch Chromatographieren an Kieselgel (Laufmittel Toluol) gereinigt wird.

Ausbeute: 42 Teile (26% d.Th.) Schmp. 80°C
NMR ($CDCl_3$, $\delta$): 1.4 (S); 1.1—1.6 (m); 2.1—2.4 (m); 7.3—8.0 (m)

| | | | |
|---|---|---|---|
| Analyse $C_{20}H_{23}O_2P$ (326) ber.: | C 73,62 | H 7,06 | P 9,51 |
| gef.: | C 73,3 | H 7,1 | P 9,6 |

Beispiel 7

In Analogie zu Beispiel 1 werden aus 88 Teilen 2-Methyl-2-äthylhexansäurechlorid und 108 Teilen Methoxydiphenylphosphin 165 Teile 2 - Methyl - 2 - Äthyl - hexanoyl - diphenylphosphinoxid als öliges Rohprodukt erhalten. Durch Säulenchromatographie an Kieselgel (Laufmittel: Toluol/Äther 3:1) erhält man das Produkt als leicht gelbliches Öl. Ausbeute 154 Teile (90% d.Th.)

NMR ($CDCl_3$, $\delta$): 1.2 (S); 0.5—2.2 (m); 7.3—8.1 (m)

| | | | | |
|---|---|---|---|---|
| Analyse $C_{21}H_{27}O_2P$ (342) | ber.: | C 73,68 | H 7,89 | P 9,06 |
| | gef.: | C, 73,9 | H 8,1 | P 9,4 |

Beispiel 8

Analog zu Beispiel 1 tropft man bei 50°C 43,2 Teile Methoxydiphenylphosphin zu 35,3 Teile 2,2-Dimethylheptancarbonsäurechlorid (®Versatic-Säurechlorid). Man rührt 3 h bei 50°C, kühlt auf 15°C ab und rührt die Mischung in eine Aufschlämmung von 60 g Kieselgel in 350 ml Toluol ein, rührt noch eine Stunde unter Eiskühlung. Dann wird abgesaugt und das Lösungsmittel unter vermindertem Druck abdestilliert. Versatoyl-diphenylphosphinoxid hinterbleibt als viskoses Öl.

Ausbeute 62 Teile (90% d.Th.)
NMR ($CDCl_3$, $\delta$): 0.4—2.3 (m); 7.2—8.1 (m)

| | | | | |
|---|---|---|---|---|
| Analyse $C_{21}H_{27}O_2P$ (342) | ber.: | C 73,68 | H 7,89 | P 9,06 |
| | gef.: | C 73,6 | H 8,1 | P 8,6 |

Beispiel 9

Zu einer Mischung aus 600 Volumen-Teilen Petroläther, 263 Teilen N,N-Diäthylanilin und 120 Teilen Isopropanol tropft man innerhalb einer Stunde bei 0°C 143 Teile Phenyldichlorphosphin. Danach wird noch 1 h bei Raumtemperatur gerührt, und dann nach Aufarbeitung wie in Beispiel 1 beschrieben destilliert. Das Diisopropoxy-phenylphosphin destilliert bei 68—72°C/40 Pa, Ausbeute 126 Teile (69% d.Th.)

158 Teile Diisopropoxyphenylphosphin werden unter gutem Rühren bei 50—60°C langsam zu 84 Teilen Pivalinsäurechlorid zugegeben. Man rührt weitere zwei Stunden und fraktioniert im Vakuum. Pivaloyl-phenylphosphinsäureisopropylester destilliert bei 119—121°C/67 Pa.

Ausbeute 112 Teile (60% d.Th.)
NMR ($CDCl_3$, $\delta$) 1,25 (S); 1,33 (t); 4,5 (m); 7,3—8 (m)

| | | | | |
|---|---|---|---|---|
| Analyse: $C_{14}H_{21}O_3P$ (268): | ber.: | C 62,68 | H 7,84 | P 11,57 |
| | gef.: | C 63,0 | H 8,0 | P 11,4 |

Beispiel 10

Zu einer Mischung aus 1000 Volumenteilen Toluol, 421 Volumenteilen N,N-Diäthylanilin und 100 Volumenteilen Methanol werden bei 0°C 214 Teile Phenyldichlorphosphin zugegeben. Danach rührt man noch 1 Stunde bei Raumtemperatur, saugt den Niederschlag von Aminhydrochlorid ab und fraktioniert. Das Dimethoxyphenylphosphin destilliert bei 46—50°C/26—39 Pa.

Ausbeute: 190 Teile (93% d.Th.)

Zu 78,7 Teilen Pivaloylchlorid werden bei 15°C 110,5 Teile Dimethoxyphenylphosphin zugetropft. Man erwärmt danach noch 30 min auf 50°C und destilliert dann das Reaktionsgemisch. Pivaloylphenylphosphinsäuremethylester geht bei 104—107°C/40 Pa über.

Ausbeute: 101,3 Teile (65% d.Th.)
NMR ($CDCl_3$, $\delta$): 1,3 (S); 3,75 (d); 7,4—8 (m).

| | | | | |
|---|---|---|---|---|
| Analyse: $C_{12}H_{17}O_3P$ (240) | ber.: | C 60,0 | H 7,08 | P 12,9 |
| | gef.: | C 59,8 | H 6,9 | P 12,4 |

Beispiel 11

Zu 163 Teilen 2-Äthylhexansäurechlorid werden bei 30°C 170 Teile Dimethoxyphenylphosphin (Beispiel 4) zugetropft.

Anschließend wird 50 min bei 50°C gerührt, dann im Ölvakuum fraktioniert.

2-Äthyl-hexanoyl-phenylphosphinsäuremethylester geht bei 160—168°C/160 Pa über.

Ausbeute: 230 Teile (81% d.Th.)
NMR ($CDCl_3$, $\delta$): 0,6—2 (m); 3,2 (q); 3,8 (d), 7,3—8 (m)

| | | | | |
|---|---|---|---|---|
| Analyse: $C_{15}H_{22}O_3P$ (281) | ber.: | C 64,06 | H 7,83 | P 11,03 |
| | gef.: | C 63,8 | H 8,1 | P 11,0 |

Beispiel 12

Zu 155 Teilen 4-Methylbenzoylchlorid, gelöst in 250 Volumenteilen Toluol, werden bei 30°C 170 Teile Dimethoxyphenylphosphin zugegeben. Man läßt 60 min nachreagieren, kühlt dann auf 0°C ab und saugt den Niederschlag ab. Nach dem Umkristallisieren aus Cyclohexan schmilzt 4-Methylbenzoylphenylphosphinsäuremethylester bei 99—101°C.

Ausbeute: 180 Teile (65% d.Th.)
NMR: 2,25 (S); 3,7 (d); 7—8,1 (m)

| | | | | |
|---|---|---|---|---|
| Analyse: $C_{15}H_{15}O_3P$ (274) | ber.: | C 65,69 | H 5,47 | P 11,31 |
| | gef.: | C 65,7 | H 5,6 | P 11,0 |

Beispiel 13

Ein deckend pigmentierter Lack wird hergestellt aus einer Mischung von 100 Teilen des Umsetzungsprodukts aus Bisphenol- A-diglydidyläther und 2 Mol Acrylsäure, 122 Teilen Butandiol-1,4-diacrylat, 6 Teilen n-Butanol, 122 Teilen $TiO_2$-Pigment. Lacke dieser Art sind dem Fachmann bekannt. Zu dieser Mischung gibt man 6,5 Teile 2-Methylbenzoyl-diphenylphosphinoxid als Photoinitiator. Der fertig formulierte Lack wird in einer Dicke von 75 $\mu$ auf Glasplatten aufgerakelt und mit einer Hg-Hochdrucklampe (Leistung 80 W/cm Bogenlänge) bestrahlt. Der Abstand Lampe — Lackfilm betrug 10 cm. Die Proben wurden in einer Inertgasatmosphäre auf einem in seiner Laufgeschwindigkeit kontinuierlich verstellbaren Transportband unter der Lampe hindurchgezogen.

Bei Transportbandgeschwindigkeiten bis zu 6 m/min erhält man kratzfeste, durchgehärtete und völlig weiße Lackfilme.

Beispiel 14

Zu einem Bindemittel aus 65 Teilen eines Umsetzungsproduktes aus Bisphenol-A-diglycidyläther mit zwei Äquivalenten Acrylsäure und 35 Teilen Butandiol-1,4-diacrylat werden jeweils drei Teile Photoinitiator gegeben. Diese Mischungen werden in einer Schichtdicke von 80 $\mu$ mit einer Rakel auf Glasplatten aufgezogen und bestrahlt (Hg-Hochdrucklampe, 80 W/cm Bogenlänge, Abstand 10 cm). Die zur Erzielung einer nagelharten, kratzfesten Oberfläche notwendige Bestrahlungsdauer wird durch die maximal mögliche Transportbandgeschwindigkeit wiedergegeben, mit der die Proben under der Lampe durchgezogen werden können. Es wurden beispielsweise folgende Werte gemessen:

Tabelle 2
Härtungsaktivität der Photoinitiatoren

| Initiator | Maximale Transportbandgeschwindigkeit in m/min | | |
|---|---|---|---|
| | unter Luft | unter Inertgas | unter Luft, Zusatz von 3% N-Phenylglycin |
| Pivaloylphenylphosphinsäuremethylester | 10 | 150 | 10 |
| Toluyl-phenylphosphinsäuremethylester | 10 | 70 | 25 |
| 2-Äthylhexanoyl-phenylphosphinsäuremethylester | — | 40 | |
| Toluyl-diphenylphosphinoxid | — | 70 | 25 |
| 2-Methylbenzoyldiphenylphosphinoxid | — | 70 | |
| Pivaloyldiphenylphosphinoxid | 11 | 150 | 25 |
| Benzoyldiphenylphosphin (US—PS 3 668 093) | <10 | <12 | |
| p-Dimethylaminobenzoyldiphenylphosphin (US—PS 3 668 093) | 12 | 12 | |

Beispiel 15

Zu einem nach Beispiel 14 hergestellten Lack werden 3% N-Phenylglycin zugegeben. Anschließend wird wie in Beispiel 14 auf Glasplatten aufgezogen und belichtet. Die Ergebnisse folgen aus Tabelle 2.

Beispiel 16

Durch Veresterung von 431 Teilen Maleinsäureanhydrid und 325 Teilen Phthalsäureanhydrid mit 525 Teilen Propylenglykol 1,2 wird ein ungesättigter Polyester hergestellt. Nach Zugabe von 0,01% Hydrochinon wird von dem Polyester eine 66 prozentige Lösung in Styrol hergestellt. 97 Teile dieses UP-Harzes werden mit 1,5 Teilen Pivaloyldiphenylphosphinoxid versetzt.

Für die Lichthärtungsversuche werden zu 100 Teilen dieser Mischung 10 Teile einer 1 prozentigen Lösung von Paraffin (Erweichungsbereich 50—52°C) in Styrol zugesetzt und das Harz auf Glasplatten mit einem Filmaufziehgerät der Spalttiefe 400 μ aufgetragen. Nach etwa einminütigem Ablüften werden die Filme mit Leuchtstofflampen (Philips TLA 05/40 W), die im Abstand von 4 cm angebracht sind, belichtet.

Nach einer Belichtungsdauer von 4 min haben die Filme eine Pendelhärte von 76 s (nach König) und sind schleif- und schwabbelfähig.

Beispiel 17

Ein nach Beispiel 14 hergestelltes Bindemittel wird mit jeweils drei Teilen eines Photoinitiators laut Tabelle 2 gemischt und anschließend in einer Schichtdicke von 76 μ auf weißes Photopapier aufgezogen und unter Inertgas mit einer Geschwindigkeit von 72 m/min unter einer Hg-Hochdrucklampe (Leistung 80 W/cm Bogenlänge) hindurchgezogen. Die so gehärteten Proben waren nagelhart und hochglänzend. Wie Tabelle 3 zeigt, übertreffen die erfindungsgemäßen Verbindungen bei weitem den Stand der Technik, der durch die Initiatoren Benzildimethylketal und das Gemisch Benzildimethylketal/Benzophenon/Methyldiäthanolamin charakterisiert ist.

Tabelle 3

Vergilbung photopolymerisierter Lacke

| Initiator | angewandte Konzentration | Vergilbung gemessen nach Yellowness--Index +) |
|---|---|---|
| Benzildimethylketal | 3% | 9,20 |
| Benzildimethylketal/ Benzophenon/Methyl-diäthanolamin (2:1:3) | 6% | 8,15 |
| Pivaloyl-diphenyl-phosphinoxid | 3% | −3,33 |
| p-Toluyl-diphenyl-phosphinoxid | 3% | −3,72 |
| Pivaloyl-phenyl-phosphinsäuremethylester | 3% | −2,34 |

+) Yellowness-Index nach ASTM D 1925—G7
mit Gerät DMC 25 der Fa. Zeiss

Beispiel 18

Zur Messung der Härtungsaktivität der erfindungsgemäßen Verbindungen in photopolymerisierbaren ungesättigten Polyesterharzen wurde der Temperaturverlauf während der Belichtung aufgezeichnet. Dazu wurden folgende Harze hergestellt:

Harz A: Durch Schmelzkondensation von Maleinsäure, o-Phthalsäure, Äthylenglykol und Propylenglykol-1,2 im Molverhältnis 1:2:2,4:0,85 erhält man einen ungesättigten Polyester mit einer Säurezahl von 50.

Harz B: Aus Maleinsäure, Tetrahydrophthalsäure und Diäthylenglykol im Molverhältnis 1:0,5:1,5 erhält man ein UP-Harz der Säurezahl 46.

Zur Anwendung werden beide Harze 65 prozentig in Styrol gelöst und mit 100 ppm Hydrochinon stabilisiert.

10 g eines solchen Harzes werden mit 0,35% des jeweiligen Photoinitiators sensibilisiert und danach in einer Weißblechschale (Durchmesser 3,8 cm) bestrahlt, die zur Wärmeisolation in Polyurethan-Hartschaum eingebettet ist. Als Strahlungsquelle dient ein UV-Feld (87 x 49 cm) aus zehn nebeneinander angeordneten Lampen (TUV 40 W/0,5, Phillips, der Abstand zur Probe beträgt 10 cm). Der Temperaturverlauf im Harz während der Härtung wird über ein Thermoelement mit Schreiber registriert. Die erhaltenen Meßwerte sind in Tabelle 4 zusammengefaßt.

Tabelle 4
Temperaturverlauf während der Photopolymerisation

| Photo-Initiator | Konzen-zentra-tion | Harz | Härtungszeit (Zeit zwischen 25°C und $T_{max}$) | maximal erreichte Proben-temperatur $T_{max}$ (°C) |
|---|---|---|---|---|
| Pivaloyl-phenylphosphin-säuremethylester | 0,35% | A | 18 min 15 s | 106 |
| | 0,35% | B | 13 min | 112 |
| Toluyl-diphenylphosphinoxid | 0,35%s | A | 15 min 15 s | 122 |
| | 0,35% | B | 10 min 5 s | 133 |
| 4-tert.-Butyl-benzoyl-di-phenylphosphinoxid | 0,35% | A | 14 min 55 s | 120 |
| Terephthaloyl-bis-diphenyl-phosphinoxid | 0,35% | A | 21 min 15 s | 109 |

**Patentansprüche**

1. Acylphosphinoxidverbindungen der allgemeinen Formel

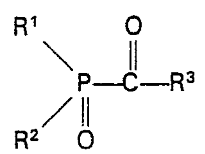 (I)

wobei

$R^1$ für einen geradkettigen oder verzweigten Alkylrest mit 1 bis 6 Kohlenstoffatomen, den Cyclohexyl- den Cyclopentyl-, einen Aryl-, halogen-, alkyl- oder alkoxyl-substituierten Aryl-, einen S- oder N-haltigen fünf- oder sechsgliedrigen heterocyclischen Rest steht;

$R^2$ die Bedeutung von $R^1$ hat, wobei $R^1$ und $R^2$ untereinander gleich oder verschieden sein können, oder für einen Alkoxyrest mit 1 bis 6 Kohlenstoffatomen, für einen Aryloxy oder einen Arylalkoxyrest steht, oder $R^1$ und $R^2$ zusammen mit dem P-Atom einen Benzo-1,3,2-dioxaphospholanring bilden;

$R^3$ für einen geradkettigen oder verzweigten Alkylrest mit 2 bis 18 Kohlenstoffatomen, einen 3 bis 12 Kohlenstoffatome enthaltenden cycloaliphatischen Rest, einen alkyl-, alkoxy-, alkylthiosubstituierten Phenyl- oder Naphthylrest, den Thienyl- oder Pyridylrest, einen $\beta$-Acetoxyäthyl- oder $\beta$-Carboxyäthylrest oder für die Gruppierung

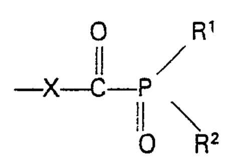

steht, worin $R^1$ und $R^2$ die oben angegebene Bedeutung haben und X für einen Phenylenrest oder einen 2 bis 6 Kohlenstoffatome enthaltenden aliphatischen oder einen 3 bis 6 Kohlenstoffatome enthaltenden cycloaliphatischen zweiwertigen Rest steht;

und wobei gegebenenfalls mindestens einer der Reste $R^1$ bis $R^3$ olefinisch ungesättigt ist, mit der Maßgabe, daß Verbindungen der Formeln

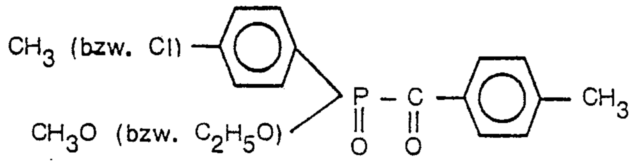

und

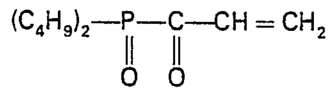

ausgenommen werden.

2. Acylphosphinoxidverbindungen nach Anspruch 1, dadurch gekennzeichnet, daß $R^3$ ein tertiärer aliphatischer Rest ist.

3. Acylphosphinoxidverbindungen nach Anspruch 1, dadurch gekennzeichnet, daß $R^3$ ein mono-, di- oder trialkylsubstituierter Phenylrest ist, wobei der oder die Alkylreste 1 bis 8 Kohlenstoffatome enthalten.

4. Verfahren zur Herstellung der Acylphosphinoxidverbindungen nach einem der vorhergehenden Ansprüche, dadurch gekennzeichnet, daß man Säurehalogenide der allgemeinen Formel

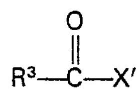

worin X' für Chlor oder Brom steht und $R^3$ die oben genannte Bedeutung hat, mit einem Phosphin der allgemeinen Formel

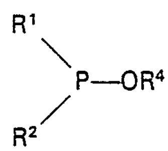

worin $R^1$ und $R^2$ die oben genannte Bedeutung haben und $R^4$ für einen geradkettigen oder verzweigten 1 bis 6 Kohlenstoffatome enthaltenden Alkylrest oder einen Cycloalkylrest mit 5 oder 6 Kohlenstoffatomen stehen, bei Temperaturen zwischen −30 und +130°C gegebenenfalls in Gegenwart eines inerten organischen Lösungsmittels umsetzt.

5. Verwendung der Acylphosphinoxide der allgemeinen Formel

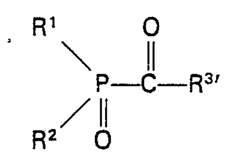

(II)

nach Anspruch 1, 2 oder 3, in der $R^{3'}$ zusätzlich zu $R^3$ einen Methyl- oder Phenylrest bedeuten kann, sowie der Acylphosphinoxid-Verbindungen der Formeln

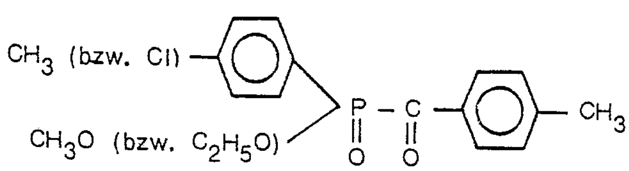

und

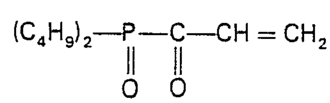

als Photoinitiatoren in photopolymerisierbaren Massen.

6. Verwendung der Acylphosphinoxide nach Anspruch 5, in Kombination mit sekundären und/oder tertiären Aminen.

**Revendications**

1. Dérivés d'oxydes d'acyl-phosphines de la formule générale

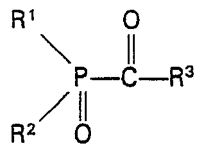 (I),

dans laquelle

$R^1$ désigne un radical alcoyle en $C_1$ à $C_6$ à chaîne droite ou ramifiée, un groupe cyclohexyle ou cyclopentyle, un groupe aryle éventuellement halo-, alcoyl- ou alcoxy- substitué ou un group hétérocyclique penta- ou hexagonal avec des atomes de soufre ou d'azote;

$R^2$ possède les significations définies pour $R^1$, $R^1$ et $R^2$ pouvant être identiques ou différents, ou peut aussi représenter un radical alcoxy en $C_1$ à $C_6$ ou un groupe aryloxy ou aryl-alcoxy, $R^1$ et $R^2$ pouvant de plus former avec l'atome de phosphore adjacent un noyau benzo-1,3,2-dioxa-phospholanne;

$R^3$ représenté un radical alcoyle en $C_2$ à $C_{18}$ à chaîne droite ou ramifiée, un groupe cycloaliphatique en $C_3$ à $C_{12}$, un groupe phényle ou naphtyle alcoyl-, alcoxy ou alcoylthio-substitué, un groupe thiényle, pyridyle, $\beta$-acétoxy-éthyle ou $\beta$-carboxy-éthyle ou un groupe de la formule

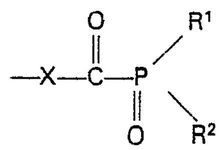

dans laquelle $R^1$ et $R^2$ possèdent la signification définie ci-dessus et X désigne un groupe phénylène, un groupe aliphatique bivalent en $C_2$ à $C_6$ ou un groupe cycloaliphatique bivalent en $C_3$ à $C_6$,

l'un au moins des restes $R^1$ à $R^3$ pouvant le cas échéant comporter une insaturation oléfinique, étant cependant exclus les composés des formules

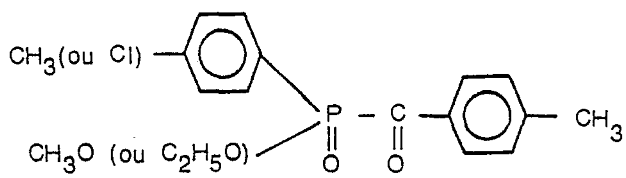

et

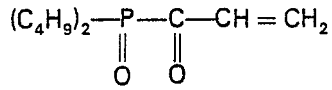 .

2. Dérivés d'oxydes d'acyl-phosphines suivant la revendication 1, caractérisés en ce que $R^3$ représente un groupe aliphatique tertiaire.

3. Dérivés d'oxydes d'acyl-phosphines suivant la revendication 1, caractérisés en ce que $R^3$ représente un groupe phényle mono-, di- ou tri-alcoyl-substitué par un ou des radicaux alcoyle en $C_1$ à $C_8$.

4. Procédé de préparation de dérivés d'oxydes d'acyl-phosphines suivant l'une des revendications précédentes, caractérisé en ce que l'on fait réagir un halogénure d'acide de la formule générale

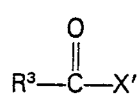 ,

dans laquelle X' désigne un atome de chlore ou de brome et $R^3$ possède la signification définie, et une phosphine de la formule générale

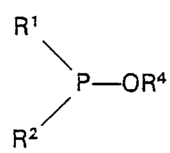 ,

dans laquelle $R^1$ et $R^2$ possèdent la signification définie et $R^4$ désigne un radical alcoyle en $C_1$ à $C_6$ à chaîne droite ou ramifiée ou un groupe cyclo-alcoyl en $C_5$ ou $C_6$, à des températures comprises entre −30 et +130°C, éventuellement en présence d'un solvant organique inerte.

5. Utilisation d'oxydes d'acyl-phosphines de la formule générale

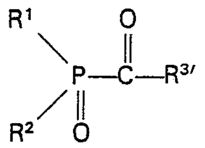

(II)

suivant l'une des revendications 1, 2 et 3, dans laquelle $R^{3'}$ possède les significations définies pour $R^3$ et peut en outre représenter un groupe méthyle ou phényle, ainsi que des oxydes d'acyl-phosphines des formules

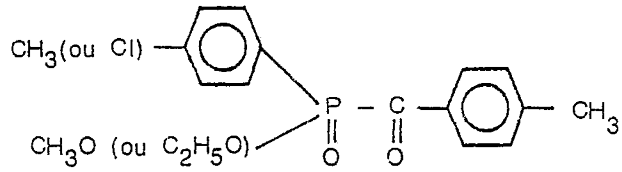

et

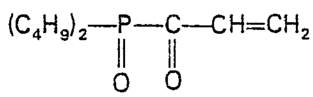

comme photo-initiateurs dans des compositions photopolymérisables.

6. Utilisation d'oxydes d'acyl-phosphines suivant la revendication 5 en combinaison avec des amines secondaires et(ou) tertiaires.

**Claims**

1. An acylphosphine oxide compound of the general formula

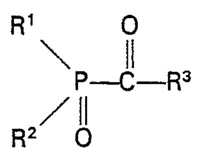

(I)

where

$R^1$ is a straight-chain or branched alkyl of 1 to 6 carbon atoms, cyclohexyl, cyclopentyl, aryl which is unsubstituted or substituted by halogen, alkyl or alkoxy, or an S-containing or N-containing five-membered or six-membered heterocyclic radical,

$R^2$ has one of the meanings of $R^1$ (but $R^1$ and $R^2$ may be identical or different), or is alkoxy of 1 to 6 carbon atoms, aryloxy or aralkoxy, or $R^1$ and $R^2$ together with the P atom form a benzo-1,3,2-dioxophospholane ring, and

$R^3$ is straight-chain or branched alkyl of 2 to 18 carbon atoms; a cycloaliphatic radical of 3 to 12 carbon atoms; phenyl or naphthyl which are substituted by alkyl, alkoxy or thioalkyl; thienyl or pyridyl; β-acetoxyethyl or β-carboxyethyl; or is the group

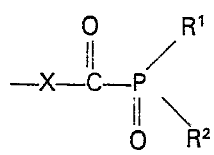

where $R^1$ and $R^2$ have the above meanings and X is phenylene, an aliphatic divalent radical of 2 to 6 carbon atoms or a cycloaliphatic divalent radical of 3 to 6 carbon atoms, and one or more of the radicals $R^1$ to $R^3$ may be olefinically unsaturated, with the proviso that compounds of the formulae

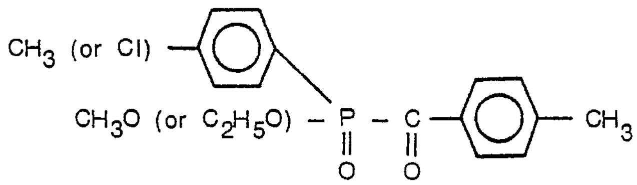

and

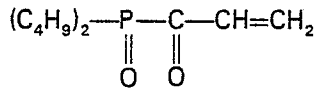

are excluded.

2. An acylphosphine oxide compound as claimed in claim 1, wherein $R^3$ is a tertiary aliphatic radical.

3. An acylphosphine oxide compound as claimed in claim 1, wherein $R^3$ is mono-, di- or tri-alkylsubstituted phenyl, each alkyl being of 1 to 8 carbon atoms.

4. A process for the preparation of an acylphosphine oxide compound as claimed in any of the preceding claims, wherein an acid halide of the general formula

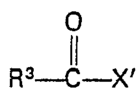

where X′ is chlorine or bromine and $R^3$ has the above meaning, is reacted with a phosphine of the general formula

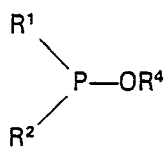

where $R^1$ and $R^2$ have the above meanings and $R^4$ is straight-chain or branched alkyl of 1 to 6 carbon atoms or cycloalkyl of 5 or 6 carbon atoms, at from −30 to +110°C, in the presence or absence of an inert organic solvent.

5. Use of an acylphosphine oxide of the general formula

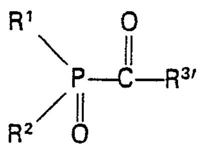

(II)

as claimed in claims 1, 2 or 3, where $R^{3'}$, in addition to $R^3$, may be methyl or phenyl, and of an acylphosphine oxide compound of the formula

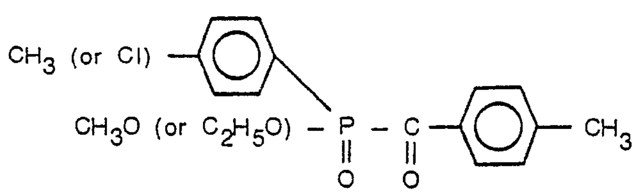

or

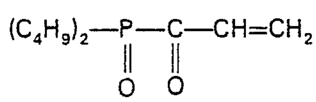

as a photoinitiator in photopolymerizable compositions.

6. Use of an acylphosphine oxide as claimed in claim 5 in combination with a secondary and/or tertiary amine.